# EUROPEAN PATENT SPECIFICATION

(11) **EP 0 392 235 B1**
(45) Date of publication and mention of the grant of the patent: **07.06.1995**
(21) Application number: 90105544.2
(22) Date of filing: 23.03.1990
(51) Int. Cl.: C23C 18/16

(54) **Process for plating a metallic deposit between functional pattern lines on a substrate**
Verfahren zur Plattierung einer metallischen Schicht zwischen funktionellen Bahnen auf einem Substrat
Procédé pour déposer un revêtement métallique entre des lignes fonctionnelles sur un substrat

(30) Priority: 24.03.1989 JP 73135/89
(43) Date of publication of application: 17.10.1990
(73) Proprietor: NIPPON PAINT CO., LTD., Osaka-shi Osaka 530 (JP)
(72) Inventor: Matsumura, Akira, Hirakata-shi, Osaka (JP); Ohata, Masashi, Osaka-shi, Osaka (JP); Ishikawa, Katsukiyo, Kuze-gun, Kyoto (JP)
(74) Representative: Hansen, Bernd, Dr. Dipl.-Chem.

(56) References cited:
- EP-A- 0 271 466
- US-A- 3 347 724
- US-A- 3 900 320
- IBM TECHNICAL DISCLOSURE BULLETIN, vol. 31, no. 5, October 1988, pp.370-372, New York, US; "Precatalyzed epoxy formulations for electroless plating"
- RCA TECHNICAL NOTES, no. 768, April 1968, pages 2-3; R.J. RYAN: "Printedcircuit techniques"
- EXTENDED ABSTRACTS, THE ELECTROCHEMICAL SOCIETY, INC. FALL MEETING, Las Vegas, Nevada, 17th - 22nd October 1976, vol. 76-2, abstract no. 273; G. MESSNER: "Imaging processes for electrolessly deposited conductors"

## Description

### FIELD OF THE INVENTION

The present invention relates to a process for forming a color filter by plating a metallic deposit between pattern lines on a substrate. More particularly, it relates to a process for plating a metallic thin deposit by electroless plating between pattern lines which work as a color filter suitable for a liquid crystal color display, whereby enhancing screening properties of unnecessary light and other properties.

### BACKGROUND OF THE INVENTION

A color filter for a liquid crystal display generally has a thin layer for screening light, called "black stripe", between pattern lines, in order to screen unnecessary light and enhance other properties. This light-screening thin layer is formed by various methods, such as a printing method (e.g. a silk screen method or an offset method), a photolithography method, a splattering method, an etching method of a vapor-deposited metal layer and the like.

It is difficult, however, for the printing method to produce pattern lines of less than 100 micrometer. The photolithography method is more accurate than the printing method, but operating processes are very complicated, so that it is difficult to actually practice the method in view of producibility and producing expense. The etching method has the same problem as the photolithography method, because its operating processes ace complicated: The conventional methods also have problems in that it is difficult to precisely form the light-screening thin layer between the circuit pattern lines.

IBM Technical Disclosure Bulletin, Vol. 31, No. 5, October 1988, pages 370-372 reveals a method for manufacturing a catalytic laminate being formed by incorporating Pd-phthalocyanine tetracarboxylic acid in a photo-sensitive resin. The pre-catalysed sample is then laminated with a permanent resist, and then patterned. In order to expose the Pd-seed, a treatment with an oxygen plasma is effected.

EP-A-0 271 466 discloses the selective catalytic activation of polymeric films by incorporating catalytic metal compounds comprising a metal such as Pd or Pt into the polymer solution, forming a film with said solution on the substrate by drying said solution, thereafter applying energy to selected areas of said layer to provide said areas with nascent clusters of said metal and applying a reducing agent to said areas to form clusters of said metal and contacting said areas with an electroless plating solution to electrolessly deposit metals on said areas.

Extended Abstracts, The Electrochemical Society, ENC. 4 Meeting Las Vegas, Nevada, 17-22.10.1976, Vols. 76-2, Abstract No. 273 reveals a method according to which a metal salt (e.g. PdCl₂-SnCl₂) is coated on the surface of a substrate to deposit metal palladium on which a negative mask is printed by normal printing process. Electroless plating is then conducted on those parts of the surface which are not covered the mask.

US-A-3,347,724 discloses a dispersion of a catalyst for electroless plating in a resinous adhesive which is adhered onto a flexible base material, followed by electroless plating.

Finally, US-A-3,900,320 includes a method according to which a mixture of a metal, a photo-polymer and a solvent is coated on a base, dried and then exposed to ultraviolet light and developed with a solvent. Finally, electroless plating is effected to form metal pattern.

### SUMMARY OF THE INVENTION

The present invention provides an improved method for producing a color display. Thus, the present invention provides a process for forming a color filter by plating a metallic deposit between functional pattern lines on a substrate, comprising (a) forming a cured film containing a catalyst for electroless plating on the substrate, (b) forming functional pattern lines on said cured film, and (c) conducting electroless plating, wherein said functional pattern lines are prepared by a printing method, a photolithography method or an electrodeposition-transfer method.

### DETAILED DESCRIPTION OF THE INVENTION

The step (a) of the present invention forms on the substrate a cured film which contains the electroless plating catalyst. The substrate used in the present invention includes a plastic plate, a glass plate and the like, but preferred is a transparent glass plate. The electroless plating catalyst can be any catalysts used for electoless plating, but includes palladium, silver, nickel, copper or gold. Preferred is palladium. In the step (a), the only necessary thing is that the catalyst is present in the cured film, so that the cured film can be any one which is used for the coating field. In case where the catalyst is palladium, the cured film can be obtained from a heat- or photo-curable aqueous coating composition. The photocurable aqueous coating composition may be composed of a water soluble polymer and a photosensitizer. Examples of the water soluble polymers are natural polymers, such as gelatin, casein, fish glue and egg albumen; synthetic polymers, such as polyvinyl alcohol, polyvinyl pyrolidone and polyacrylamide; and the like. Examples of the photosensitizers are materials which arises cross-linking reactions with the water soluble polymer, for example dichromates, such as ammonium dichromate, sodium dichromate, potassium dichromate etc.; diazonium salts, such as p-diazophenylamine, 1-diazo-4-dimethylaminobanzene hydrofluoroborate, 1-diazo-3-methyl-4-dimethylaniline sulfate, 1-diazo-3-monoethylnaphthylamind etc. The heatcurable aqueous composition may be composed of a water soluble polymer and a curing agent. Examples of the water soluble polymer are polyester resin, acryl resin and the like. In the aqueous coating composition, palladium chloride is reduced with stannous chloride in the presence of acid to form palladium metal which is functioned as an electroless plating catalyst.

The aqueous coating composition may be applied onto the substrate and then cured by heat or light. An application method and curing conditions are known to the art.

In the step (b), the functional pattern lines are formed on the catalyst-containing cured film of the step (a). The forming method of the functional pattern lines is a printing method (e.g. offset, silk screen etc.), a photolithography method or an electrodeposition-transfer method of Japanese Kokai Publication 22379/1989. By "functional pattern lines" are meant pattern lines which fulfil functions, such as color filter. In the case of the color filter, the functional pattern lines are generally colored with red, blue or green pigment. It is preferred that the functional pattern lines are cured or cross linked by heat or light so as not to remove from the substrate.

In the step (c) of the present invention, electroless plating is conducted in a plating bath to form a metallic deposit between functional pattern lines. The plating solution for electroless plating may be prepared from an electroless nickel plating composition, an electroless nickel alloy plating composition, an electroless cobalt plating composition, an electroless tin plating composition, an electroless gold plating composition and the like, which are known to the art. Electroless plating may be carried out at 5 to 95 °C for 0.1 to 24 hours.

In the present invention the functional pattern lines are formed on the catalyst-containing cured film, so that the place on which light screening metallic deposit is formed appears, but other places are covered with the pattern line. Accordingly, the metallic deposit is precisely plated on the place to be plated. The process of the present invention is also very simple and easy.

### EXAMPLES

The present invention is illustrated by the following Examples.

### Example 1

### (1) Step (a)

An aqueous coating composition which contained a catalyst for electroless Ni-P plating was prepared by mixing ingredients shown in Table 1. The composition was applied onto a glass substrate having a thickness of 1.1 mm to form a coating of 0.2 micrometer. The coated film was heated at 80 °C for 10 minutes to dry and then cured by ultraviolet light of 200 mJ/cm² from an extra high pressure mercury lamp (available from Oak Co., Ltd. as Polymer Printer HMW-40-1).

**Table 1**

| Ingredients | Parts by weight |
|---|---|
| Gelatin | 20 |
| Ammonium bichromate | 4 |
| Palladium chloride/stannous chloride colloidal solution¹ | 2 |
| 110 ml/l Hydrochloric acid | 2 |
| Water | 72 |
| Total | 100 |

| | |
|---|---|
| ¹ An aqueous solution of 1.5 g/l of palladium chloride and 100 g/l of stannous chloride | |

### (2) Step (b)

Red, blue and green inks for pattern lines were prepared by mixing ingredients shown in Table 2. The color pattern lines Were formed on the coated substrate of the step (a) from the three inks by photolithography technique. The pattern lines ware cured at 175 °C for 30 minutes and had 1.5 »m (micron) thickness.

**Table 2**

| Ingredients | Parts by weight | | |
|---|---|---|---|
| | Blue | Red | Green |
| Polyimide precursor¹ | 357 | 357 | 357 |
| Ethyleneglycol monomethyl ether | 606 | 606 | 606 |
| N-phenyl-γ -aminopropyltrimethoxysilane | 1.4 | 1.4 | 1.4 |
| Phthalocyanine blue | 35.7 | - | - |
| Azo metal salt red pigment | - | 35.7 | - |
| Phthalocyanine green | - | - | 35.7 |
| Total | 1000.0 | 1000.0 | 1000.0 |

| | | | |
|---|---|---|---|
| ¹ 1 N Methyl pyrolidone solution of polyamic acid (solid content = 20 %) | | | |

### (3) Step (c)

The resultant glass substrate of the step (b) was immersed in an Ni-P electroless plating solution at 70 °C for 30 minutes. The plating solution contained 1 mol/l of nickel sulfate, 2 mol % of ammonia water, 2 mol/l of sodium hypophosphite and 2 mol/l of sodium hydroxide. The immersed substrate was rinsed with water and heated at 80 °C for 10 minutes to obtain a color filter. The color filter had a light screening metallic deposit of 1.3 micrometer which was precisely plated between color pattern lines.

### Example 2

The color patterned substrate of step (b) was prepared as generally described in Example 1, with the exception that the color pattern lines were formed by screen printing instead of photolithoraphy technique. The red pattern line had 2.0 »m (micron) thickness, the green line had 2.1 »m (micron) thickness and the blue line had 2.3 »m (micron) thickness.

The resultant glass substrate was immersed in an Ni-P electroless plating solution of Example 1 at 50 °C for one hour. The immersed substrate was rinsed with water and heated at 80 °C for 10 minutes to obtain a color filter. The color filter had a light screening metallic deposit of 1.5 micrometer which was precisely plated between color pattern lines.

### Example 3

A color filter was prepared as generally described in Example, with the exception that tie aqueous coating composition which contained a catalyst for electroless Ni-P plating was prepared from ingredients shown in Table 3, instead of the ingredients of Table 1. The obtained color filter had a light screening metallic deposit which was precisely plated between color pattern lines.

**Table 3**

| Ingredients | Parts by Weight |
|---|---|
| Triethyleneglycol dimethacrylate | 35 |
| 1-(4-Dodecylphenyl)-2-hydroxy-2-methylpropane-1-one | 1 |
| Palladium chloride/stannous chloride colloidal solution¹ | 2 |
| 110 ml/l Hydrochloric acid | 2 |
| Water | 60 |
| Total | 100 |

| | |
|---|---|
| ¹ An aqueous solution of 1.5 g.l of palladium chloride and 100 g/l of stannous chloride | |

## Claims

1. A process for forming a color filter by plating a metallic deposit between functional pattern lines on a substrate, comprising:
(a) forming a cured film containing a catalyst for electroless plating on the substrate;
(b) forming functional pattern lines on said cured film; and
(c) conducting electroless plating;
wherein said functional pattern lines are prepared by a printing method, a photolithography method or an electrodeposition-transfer method.

2. The process according to claim 1 wherein said substrate is a plastic plate or a glass plate.

3. The process according to claim 1 or 2 wherein said catalyst for electroless plating is palladium.

4. The process according to any one of the claims 1 to 3 wherein said cured film is obtained from a heat-or photo-curable aqueous coating composition.

5. The process according to claim 3 wherein said palladium catalyst is prepared by reducing palladium chloride with stannous chloride in the presence of acid.

## Patentansprüche

1. Verfahren zur Ausbildung eines Farbfilters durch Plattieren einer metallischen Abscheidung zwischen die Linien eines Funktionsmusters auf einem Substrat, umfassend:
(a) Ausbilden eines gehärteten Films, enthaltend einen Katalysator für stromloses Plattieren auf der Oberfläche;
(b) Ausbilden von Linien eines Funktionsmusters auf dem gehärteten Film; und
(c) Durchführen des stromlosen Plattierens;
worin die Linien des Funktionsmusters durch ein Druckverfahren, ein photolithographisches Verfahren oder ein Elektroabscheidungs-Transferverfahren erzeugt werden.

2. Verfahren nach Anspruch 1, worin das Substrat eine Plastikplatte oder eine Glasplatte ist.

3. Verfahren nach Anspruch 1 oder 2, worin der Katalysator für das stromlose Plattieren Palladium ist.

4. Verfahren nach einem der Ansprüche 1 bis 3, worin der gehärtete Film aus einer hitze- oder lichthärtbaren wäßrigen Überzugszusammensetzung erhalten wird.

5. Verfahren nach Anspruch 3, worin der Palladiumkatalysator durch Reduzieren von Palladiumchlorid mit Zinn-(II)-Chlorid in Gegenwart von Säure hergestellt wird.

## Revendications

1. Procédé de formation d'un filtre chromatique par plaquage d'un dépôt métallique sur un support entre des lignes de motif fonctionnel, comportant les étapes consistant à:
(a) former un film durci contenant un catalyseur pour plaquage sans courant sur le support;
(b) former des lignes de motif fonctionnel sur ledit film durci; et
(c) conduire un plaquage sans courant;
dans lequel lesdites lignes de motif fonctionnel sont préparées par un procédé d'impression, un procédé photolithographique ou un procédé de transfert par électrodéposition.

2. Procédé selon la revendication 1, dans lequel ledit support est une plaque de plastique ou une plaque de verre.

3. Procédé selon la revendication 1 ou 2, dans lequel ledit catalyseur de plaquage sans courant est le palladium.

4. Procédé selon l'une quelconque des revendications 1 à 3, dans lequel ledit film durci est obtenu à partir d'une composition de revêtement aqueuse, thermo-durcissable ou photo-durcissable.

5. Procédé selon la revendication 3, dans lequel ledit catalyseur de palladium est préparé par réduction de chlorure de palladium par du chlorure stanneux, en présence d'un acide.
